Europäisches Patentamt

European Patent Office

Office européen des brevets

(19)

(11) Veröffentlichungsnummer: **0 204 356**
**B1**

(12) **EUROPÄISCHE PATENTSCHRIFT**

(45) Veröffentlichungstag der Patentschrift: **29.08.90**

(21) Anmeldenummer: **86200721.8**

(22) Anmeldetag: **29.04.86**

(51) Int. Cl.⁵: **C 23 C 16/50, C 23 C 16/04**

(54) **Verfahren zur glimmentladungsaktivierten reaktiven Abscheidung von elektrisch leitendem Material aus einer Gasphase.**

(30) Priorität: **04.05.85 DE 3516078**

(43) Veröffentlichungstag der Anmeldung:
**10.12.86 Patentblatt 86/50**

(45) Bekanntmachung des Hinweises auf die
Patenterteilung:
**29.08.90 Patentblatt 90/35**

(84) Benannte Vertragsstaaten:
**AT BE CH DE FR GB IT LI NL SE**

(56) Entgegenhaltungen:
**WO-A-81/03133**
**DE-B-1 251 617**
**GB-A-2 030 180**

**PATENT ABSTRACTS OF JAPAN, Band 9, Nr. 211 (C-300)1934r, 29. August 1985; & JP-A-60 77 975 (NIPPON SHINKU GIJUTSU K.K.) 02-05-1985**

(73) Patentinhaber: **Philips Patentverwaltung GmbH Wendenstrasse 35 Postfach 10 51 49 D-2000 Hamburg 1 (DE)**
(84) **DE**

(73) Patentinhaber: **N.V. Philips' Gloeilampenfabrieken Groenewoudseweg 1 NL-5621 BA Eindhoven (NL)**
(84) **BE CH FR**

(72) Erfinder: **Gärtner, Georg, Dr. Martelenberger Weg 16B D-5100 Aachen (DE)**
Erfinder: **Janiel, Peter Otto-Dix-Strasse 1 D-5102 Würselen (DE)**
Erfinder: **Lydtin, Hans, Dr. Am Göpelschacht 9 D-5190 Stolberg (DE)**

(74) Vertreter: **Piegler, Harald, Dipl.-Chem. et al Philips Patentverwaltung GmbH Wendenstrasse 35 Postfach 10 51 49 D-2000 Hamburg 1 (DE)**

Courier Press, Leamington Spa, England.

## Beschreibung

Verfahren zur glimmentladungsaktivierten reaktiven Abscheidung von elektrisch leitendem Material aus einer Gasphase.

Die Erfindung betrifft ein Verfahren zur reaktiven Abscheidung von rohrförmigen Körpern aus elektrisch leitendem Material aus einer strömenden Gasphase auf einem rohrförmigen Substrat, wobei zwischen einer Innenelektrode und einer Außenelektrode, von denen eine rohrförmig ausgebildet ist und als Substrat dient, eine Glimmentladung erzeugt wird.

Ein Verfahren ähnlicher Art ist aus der GB-A-2 030 180 bekannt. Bei dem darin beschriebenen Verfahren wird eine drahtförmige Innenelektrode verwendet, die sich konzentrisch durch den gesamten Innenraum erstreckt, der von einer rohrförmigen Außenelektrode umgeben ist. Nach Zündung der Glimmentladung wird zunächst eine Schicht aus elektrisch leitendem Material auf der Innenseite der Außenelektrode abgeschieden. Nach kurzer Zeit besteht die Gefahr, daß dünne elektrisch leitende Schichten auch zwischen den Elektroden aufwachsen und einen Kurzschluß bewirken, so daß die Glimmentladung erlischt. In dem genannten Dokument werden keine Maßnahmen angegeben, die einen Kurzschluß verhindern könnten. Für eine Erzeugung von Schichten mit Dicken, die größer als einige Mikrometer sind, z.B. von 100μm dicken Schichten, ist das bekannte Verfahren daher weniger geeignet. Außerdem haben die so erzeugten Schichten, bedingt durch unterschiedliche Plasmadichten, Temperaturinhomogenitäten und durch Materialverarmung der Gasphase, ein ungleichmäßiges Dickenprofil über die Substratrohrlänge.

Der Erfindung liegt die Aufgabe zugrunde, ein Verfahren zur glimmentladungsaktivierten reaktiven Abscheidung von selbsttragenden rohrförmigen Körpern aus elektrisch leitendem Ein und vor allem Mehrkomponentenmaterial mit Wanddicken > 20μm zu schaffen Insbesondere soll dafür gesorgt werden, daß die Elektroden nicht durch aufwachsende leitfähige Oberflächenschichten kurzgeschlossen werden und so die Glimmentladung erlischt.

Diese Aufgabe wird erfindungsgemäß dadurch gelöst, daß bei einem Verfahren der eingangs genannten Art

(a) eine gesteuerte Hin- und Herbewegung der Innen elektrode relativ zur Außenelektrode in Rohrrichtung erfolgt,

(b) zwischen der Innenelektrode und der Außenelektrode eine lokal begrenzte Glimmentladungszone erzeugt und während der Abscheidung beibehalten wird,

(c) Gasbarrieren geschaffen werden, um die Bildung von elektrisch leitenden Schichten auf elektrisch isolierenden Konstruktionsteilen im Reaktionsraum zu verhindern, und

(d) die Temperatur im Substratbereich auf einem niedrigen Wert konstant gehalten wird, bei dem die thermische Abscheiderate klein ist gegenüber der Abscheiderate mit Glimmentladung.

Durch die gesteuerte Hin- und Herbewegung der Innenelektrode wird ein gleichmäßiges Schichtdickenprofil über den gesamten Hub der Elektrodenbewegung erzielt. Die Geschwindigkeit der Elektrodenbewegung liegt z.B. in der Größenordnung von 20 Sekunden pro Periode entsprechend 1 cm/s.

Die lokale Begrenzung der Glimmentladungazone und damit eine räumliche Konzentration von Plasmaenergie hat den Zweck, die Taper vor und nach den Hubumkehrpunkten zu reduzieren und die Abscheidung auf den Bereich der Elektrodenrelativbewegung zu beschränken. Unter Tapern sind Abscheidungsbereiche mit nicht ausreichend konstanten geometrischen Eigenschaften und/oder mit nicht ausreichend konstanter Materialzusammensetzung zu verstehen.

Zum Aufrechterhalten einer stabilen lokalisierten Glimmentladungszone während längerer Beschichtungsdauern werden an diskreten Stellen im Reaktionsraum elektrisch isolierende Konstruktionsteile verwendet, deren Bewuchs mit einer elektrisch leitfähigen Schicht, die diese Bedingungen zerstören würde, d.h. bis zu Überschlägen und dem Erlöschen der Glimmentladung führen würde, durch geeignete, noch näher zu beschreibende Maßnahmen verhindert wird.

Die Konstanthaltung der Temperatur im Substratbereich erfolgt z.B. durch Wärmeleitung und/oder lokale Erhitzung bzw. Kühlung. Durch diese Konstanthaltung wird erreicht, daß Temperaturinhomogenitäten nicht zu einem lokal unterschiedlichen Dickenprofil und (bei mehreren Komponenten) Konzentrationsprofil führen. Ein schneller Temperaturausgleich über die Substratoberfläche bewirkt außerdem, daß die lokale Oberflächenerhitzung durch die Plasmaenergie nicht die Wirkung des Plasmas in Form von Ionisation und Dissoziation durch zu hohen thermischen Untergrund kaschiert. Die Temperatur im Substratbereich wird dabei auf einem niedrigen Wert gehalten, bei dem die thermische Abscheiderate klein ist gegenüber der Abscheiderate mit Glimmentladung. Etwaige Temperatureinflüsse auf die Totalabscheidungsrate werden durch diese Maßnahme unterdrückt.

Insgesamt gesehen, werden demnach durch das erfindungsgemäße Verfahren elektrisch leitende Schichten bestehend aus einer oder mehreren Komponenten mit konstantem Dickenund Konzentrationsprofil über die gesamte Rohrlänge bei Dicken $\geq$ 20μm, typischerweise 50 bis 100μm, erzielt, die in dieser Homogenität sonst nicht realisierbar sind.

Bei bevorzugten Ausgestaltungen des erfindungsgemäßen Verfahrens wird das elektrisch leitende Material entweder auf der Innenseite der als Substrat dienenden und somit rohrförmig ausgebildeten Außenelektrode oder auf der Außenseite der als Substrat dienenden und somit rohrförmig ausgebildeten Innenelektrode abgeschieden.

Vorzugsweise wird bei den Maßnahmen (b) und (d) die in der Glimmentladungszone verbrauchte Plasmaleistung gegenüber der thermischen Leistungszu- oder -abführung so hoch eingestellt, daß die Zusammensetzung von abgeschiedenem elektrisch leitendem Mehrkomponentenmaterial im wesentlichen durch die Anteile der abzuscheidenden Konstituenten in der Gasphase vorgegeben wird. Dies hat den Vorteil, daß die für jede Komponente unterschiedlichen Abscheidebedingungen des thermischen CVD-Verfahrens keine Rolle mehr spielen. Man erhält demnach bei der Kodeposition mehrerer Substanzen einen zusätzlichen Freiheitsgrad zur Einstellung gewünschter Mischungsverhältnisse, wodurch gewisse Konzentrationsverhältnisse überhaupt erst ermöglicht werden. Man kann hierbei z.B. die Temperatur im Substratbereich auf einem Wert konstant halten, bei dem die thermische Abscheiderate höchstens ein Zehntel der Abscheiderate mit Glimmentladung beträgt.

Die Bildung von elektrisch leitenden Schichten auf elektrisch isolierenden Konstruktionsteilen kann durch folgende Maßnahmen verhindert werden:

(α) durch Ausbildung von Spalten in den elektrisch isolierenden Konstruktionsteilen ("Totvolumen") oder von Spalten, bei denen mindestens ein Teil der Innenfläche aus elektrisch isolierendem Material besteht, wobei die Spalte so ausgebildet sind, daß sie während der reaktiven Abscheidung fast ausschließlich durch gasförmige Reaktionsendprodukte gefüllt sind, und/oder

(β) durch geeignete Wahl des Materials, aus dem die elektrisch isolierenden Konstruktionsteile wenigstens an der Oberfläche bestehen, so daß über eine Ätzreaktion der strömenden Gasphase mit der Oberfläche dieser Teile ein Gas entsteht, und/oder

(γ) durch eine zusätzliche Inertgasspülung.

Durch diese Verfahrensvarianten werden besonders stabile, lokalisierte und wirkungsvolle Gasbarrieren erzielt.

Die lokale Begrenzung der Glimmentladungszone (Maßnahme (b)) wird vorzugsweise durch folgende Maßnahmen eingestellt:

(α) Formgebung und geometrische Dimensionierung der nicht als Substrat dienenden Elektrode und deren Oberflächenabstände zur rohrförmigen Elektrode nach Maßgabe des Paschen-Gesetzes und/oder

(β) Isolationsumhüllung der Stromzuführung zur Innenelektrode, sofern diese nicht als Substrat dient, gegebenenfalls unter

(γ) Ausbildung von mindestens einem umlaufenden Spalt in der Isolationsumhüllung oder einem Spalt, bei dem mindestens ein Teil der Innenfläche aus elektrisch isolierendem Material besteht, wobei der Spalt so ausgebildet ist, daß er während der reaktiven Abscheidung fast ausschließlich durch gasförmige Reaktionsendprodukte gefüllt ist, und/oder

(δ) eine Längsausdehnung der metallischen Oberfläche der nicht als Substrat dienenden Elektrode, die in Rohrrichtung weniger als ein Drittel der Längsausdehnung des Substrats beträgt.

Nach dem Paschen-Gesetz hängt laut "Enzyklopädie Naturwissenschaft und Technik" Band 4 (Weinheim 1981) S. 3197, die Zündspannung $U_z$ einer Gasentladung zwischen zwei ebenen ausgedehnten Elektroden nur vom Elektrodenabstand d und dem Gasdruck p nur in der Form

$$U_z = f(p \cdot d)$$

ab, d.h. nur von der Gesamtteilchenzahl zwischen den Elektroden pro Fläche. $U_z$ besitzt bei $p \cdot d \approx 1$ Pa $\cdot$ m ($10^{-5}$ bar.m) ein Minimum von etwa 250 bis 300 V (je nach Gasart). Bei größeren Werten von $p \cdot d$ nimmt die Zündspannung zu, da die Zahl der Stöße der Elektronen wächst und damit bei einem Stoß weniger Energie für die Ionisierung zur Verfügung steht. Bei kleineren Werten von $p \cdot d$ nimmt dagegen die Zahl der ionisierenden Stöße ab, da einige Elektronen die Gegenelektrode erreichen, ohne mit neutralen Gasatomen zusammenzustoßen. Wenn möglich, sucht sich die Entladung dann einen längeren Weg, auf dem das Produkt $p \cdot d$ einen Wert erreicht, bei dem die Zündspannung niedriger ist.

Der umlaufende Spalt in der Isolationsumhüllung der Innenelektrode bzw. der Spalt, bei dem mindestens ein Teil der Innenfläche aus elektrisch isolierendem Material besteht, ist zweckmäßigerweise derart breit und tief, daß ein durchgehender Bewuchs mit elektrisch leitendem Material vermieden wird, z.B. 1 mm breit und 40 mm tief. Der Spalt ist in diesem Fall dann auch geknickt, d.h. er verläuft zunächst senkrecht zur Oberfläche und dann parallel zur Oberfläche der Umhüllung. Wenn nur ein Teil der Innenfläche des Spalts aus elektrisch isolierendem Material besteht, muß zumindest der Spaltboden elektrisch isolierend sein.

Vorzugsweise wird bei der Maßnahme (a) die Innenelektrode in Rohrrichtung periodisch oder aperiodisch gesteuert längs der Außenelektrode hin- und herbewegt. Eine periodische Steuerung erfolgt z.B. durch einen Funktionsgenerator mit einem periodischen Spannungsverlauf, der Sollwerte für Umdrehungszahl und Umkehrpunkte für einen Gleichstrommotor vorgibt, dessen Rotationsbewegung über ein Getriebe in eine Linearbewegung umgesetzt wird. Die periodische Steuerung bewirkt ein gleichmäßiges Dicken-und Konzentrationsprofil über die Hublänge.

Eine aperiodische Steuerung erfolgt z.B. durch eine externe Vorgabe von momentanen Sollwerten durch einen Rechner basierend z.B. auf weiteren Prozeßdaten. Die weitere Umsetzung erfolgt wie oben. Eine nicht- oder fast-periodische Steuerung dient zum Ausgleich von längerfristigen Driften und zum Ausgleich von Randtapern. Es ist auch möglich, die Motor-Umdrehungszahl von Zyklus zu Zyklus zu verändern.

Ferner ist es vorteilhaft, daß bei der Maßnahme (d) das, gesamte rohrförmige Substrat, also das Substratrohr, durch einzelne, getrennt regelbare Heiz- bzw. Kühlzonen und/oder durch Wahl eines Materials oder einer Vorrichtung mit schnellem Wärmeausgleich trotz der lokalen Wärmebelastung in der Glimmentladungszone auf annähernd konstanter Temperatur gehalten wird. Eine Vorrichtung mit schnellem Wärmeausgleich ist z.B. ein Wärmeleitrohr (engl. "heat pipe"), das konzentrisch um das Substratrohr innerhalb der Ofenummantelung angeordnet ist, innen hohl ist und mit einem Alkalimetalldampf gefüllt ist. Der schnelle Temperaturausgleich über das Substratrohr hat zur Folge, daß die in der Glimmentladungszone auftretende starke Zusatzerhitzung schnell an die Außenzonen abgegeben wird und dadurch bei überall konstanter niedriger Substrattemperatur der Untergrund einer rein thermischen Abscheidung keine Rolle mehr spielt. Außerdem erfolgt die temperaturabhängige Ausdehnung und Schrumpfung ziemlich gleichmäßig.

Unter "rohrförmig" ist in den vorstehenden Ausführungen zu verstehen, daß das Substrat und die Außenelektrode im allgemeinen einen Querschnitt in Form einer geschlossenen ebenen Kurve haben. Der Querschnitt ist z.B. kreisförmig, elliptisch oder vieleckig. Vorzugsweise werden das Substratrohr zylinderförmig, d.h. mit kreisförmigem Querschnitt, und die nicht als Substrat dienende Elektrode rotationssymmetrisch gewählt, wobei das Substratrohr gegebenenfalls aus mehreren Einzelrohren übereinandergestapelt wird und die nicht als Substrat dienende Elektrode koaxial angeordnet wird. Das Substrat ist z.B. ein Zylinder, auf dem das leitfähige Material abgeschieden wird. Bei nichtleitendem Substratmaterial wird erst durch ein thermisches CVD-Verfahren eine dünne leitende Schicht aufgebracht. Bei einer Innenbeschichtung sitzt die Innenelektrode im Innern dieses Zylinders z.B. als Scheibe auf einer koaxialen Elektrodenzuführung, die durch einen Isolator, z.B. einen Zylinder aus Glas oder Aluminiumoxid-Keramik, abgeschirmt wird. Eine andere Form der Innenelektrode ist z.B. ein kurzer Stab mit in Richtung Zuführung davorsitzenden Verdickungen. Durch diese Ausführungsformen wird erreicht, daß die Glimmentladungszone sich nach Maßgabe des Paschen-Gesetzes in einem kleinen Bereich um den Elektrodenkopf herum ausbildet.

Vorzugsweise werden die Innenelektrode als Anode und die Außenelektrode als Kathode gepolt — mit anderen Worten:

Die Innenelektrode befindet sich vorzugsweise auf positivem Potential bezogen zur Außenelektrode. Damit wird erreicht, daß mehr auf dem Substratrohr abgeschieden wird als auf der Innenelektrode (Verhältnis etwa 2:1).

Um die Entladungsbedingungen, d.h. Strom-Spannungs-Kennlinie und Zündspannung als Funktion von Druck und Elektrodenabstand, in Richtung auf hohe Plasmaleistung bei ausreichend hohem Druck und ausreichend hohen Entladungsströmen anzupassen, ist es zweckmäßig, der strömenden Gasphase ein Inertgas, z.B. ein Edelgas, zuzusetzen. Hierfür kommt insbesondere Argon in Betracht, weil sich dadurch erstens die Glimmentladung wegen der niedrigen Zündspannung einfach zünden läßt und weil es zweitens ohnehin als Trägergas verwendet wird.

Die strömende Gasphase enthält bei der Abscheidung von Mehrkomponentenmaterial vorzugsweise mindestens ein Halogenid oder Carbonyl von Wolfram, Molybdän, Tantal, Niob, Rhenium, Hafnium, Iridium, Osmium, Platin, Rhodium, Ruthenium und/oder Zirkonium und als weitere Komponente mindestens eine metallorganische Verbindung eines Elements der Gruppe IIIb des Periodensystems sowie zusätzlich ein Inertgas, z.B. ein Edelgas, und gegebenenfalls, z.B. bei Anwesenheit eines Halogenids, Wasserstoff.

Das erfindungsgemäße Verfahren kann ohne Schwierigkeit zur Herstellung von Metallzylindern benutzt werden, vor allem von solchen aus Refraktärmetallen, die sich wegen ihrer Sprödigkeit erschwert oder gar nicht (wie z.B. Wolfram oder Wolfram mit $\geqq$ 5% ThO$_2$) zu dünnwandigen Metallzylindern verarbeiten lassen. Statt Wolfram können auch Molybdän, Rhenium, Tantal, Niob u.ä. in dünnwandiger Metallzylinderform hergestellt werden. Besonders vorteilhaft kann auch eine Simultan-Abscheidung von Wolfram, Molybdän usw. mit anderen Metall(oxiden), wie z.B. den Metall(oxiden) der Seltenen Erden oder ThO$_2$, ZrO$_2$, HfO$_2$, durchgeführt werden.

Bei einer bevorzugten Ausführungsform des erfindungsgemäßen Verfahrens, insbesondere zur Herstellung von Zylinderkathoden für Elektronenröhren, enthält die strömende Gasphase Wolframhexafluorid, Wasserstoff und mindestens eine metallorganische Thoriumverbindung zugesetzt und es wird ein elektrisch leitendes Material, bestehend aus Wolfram, Wolframcarbid und Thoriumoxid, abgeschieden. Als metallorganische Thoriumverbindungen kommen z.B. Thorium-heptafluordimethyloctandionat, Th(fod)$_4$, oder Thorium-trifluor-acetylacetonat, Th(tfa)$_4$, in Betracht. Statt Wolframhexafluorid kann auch z.B. Molybdänhexafluorid oder Rheniumhexafluorid benutzt werden.

Bei einer weiteren bevorzugten Ausführungsform des erfindungsgemäßen Verfahrens wird das Inertgas über zwei getrennt regelbare Gasflußwege zugesetzt, wobei eine Inertgaszuführung durch einen, mit der pulverförmigen metallorganischen Thoriumverbindung gefüllten, vorgeheizten Sättiger erfolgt. Auf diese Weise wird erreicht, daß sowohl der Trägergasfluß als auch der Gesamt-Inertgasdurchsatz getrennt einstellbar sind.

Um die mechanisch-thermische Stabilität (Niedertemperatur-Duktilität) der zuvor erwähnten thorierten Wolframzylinder zu erhöhen, ist es zweckmäßig, dem Ausgangsgasgemisch noch eine weitere Dotierung beizugeben, nämlich Rheniumhexafluorid.

Zur Herstellung freitragender Zylinder aus elektrisch leitendem Material, insbesondere aus Wolfram, wird vorzugsweise ein rohrförmiges Substrat verwendet, das aus Pyrographit, Quarz, Molybdän oder Kupfer besteht; das rohrförmige Substrat wird nach beendeter Abscheidung entfernt. Kupfer wird z.B. durch Ätzen oder Verdampfen entfernt.

Besonders vorteilhaft ist es, als Substrat einen Quarzzylinder zu verwenden, der durch Pyrolyse einer metallorganischen Thoriumverbindung mit einer dünnen, auf Wolfram nicht haftenden Zwischenschicht aus Thoriumcarbid und Kohlenstoff thermisch vorbeschichtet wird, worauf dann das elektrisch leitende Material abgeschieden wird und nach Beendigung der Abscheidung und Abkühlung als selbsttragender Zylinder mit z.B. $\geq 30\mu m$ Wandstärke einfach aus dem Quarzrohr herausgezogen wird.

Beim Umschalten auf eine andere Gaszusammensetzung im Laufe des Verfahrens ist es vorteilhaft, die Glimmentladung nicht abzuschalten, da anderenfalls die Gefahr besteht, daß die entstandenen Schichten delaminieren.

Die Erfindung wird im folgenden an Hand einer Zeichnung und einiger Ausführungsbeispiele näher erläutert. In der Zeichnung zeigen:

Fig. 1 eine Vorrichtung zur Durchführung von glimmentladungsaktivierten reaktiven Abscheidungen schematisch im Schnitt,

Fig. 2 eine Abwandlung der Vorrichtung nach Fig. 1 schematisch im Schnitt,

Fig. 3 die Wolfram-Abscheiderate als Funktion der Plasmaleistung in einem Diagramm und

Fig. 4 die Wolfram-Abscheiderate als Funktion der reziproken Substrattemperatur bei konstanter Plasmaleistung in einem Diagramm.

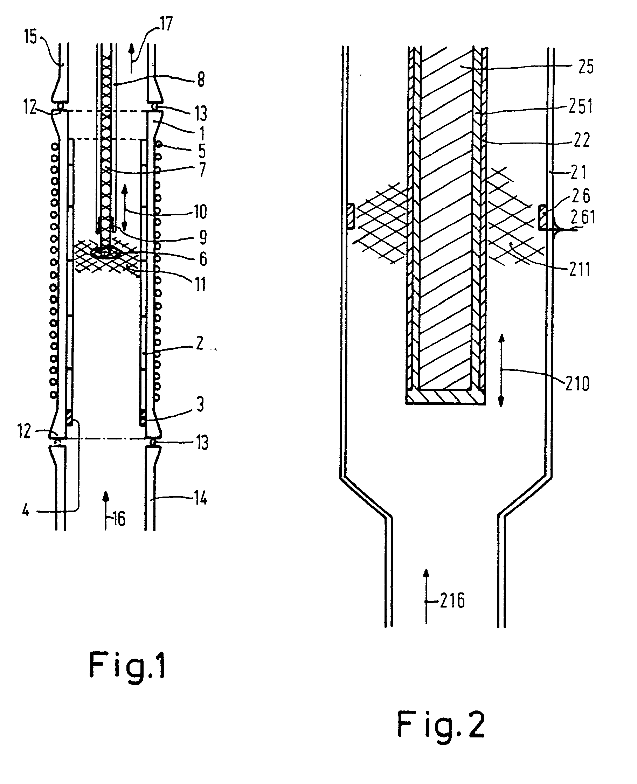

Fig. 1 zeigt schematisch einen Ausschnitt aus dem Bereich der Reaktionskammer. In einem Hüllrohr 1, das z.B. aus Quarz oder Edelstahl besteht und zusammensteckbar sein kann, sind Substratzylinder 2 auf einem Kupferring 3 koaxial aufgestapelt. Vom Kupferring 3 führt ein elektrischer Anschluß 4 für die Kathode über eine (nicht dargestellte) Vakuum-Stromdurchführung zum Minus-Pol eines (nicht dargestellten) Gleichstrom-Netzgeräts. Um das Hüllrohr sind zusätzlich Heizwicklungen 5 gewickelt, um die Substratzylinder bzw. Substratrohre auf einer definierten Temperatur zu halten, z.B. auf einer Temperatur von 500°C oder mehr, wozu eine Heizleistung von 280 bis 300 W erforderlich ist. Koaxial in der Rohrachse befindet sich eine Innenelektrode 6, die normalerweise als Anode geschaltet ist, und die längs dieser Achse über einen (nicht dargestellten) Linearantrieb verschiebbar ist. Die als Scheibe ausgebildete Innenelektrode ist auf einen Montagestab 7 aus Edelstahl (V2A) aufgeschraubt, der zugleich als Stromzuführung dient. Der Montagestab 7 ist von einem Abschirmzylinder 8 aus $Al_2O_3$-Keramik umhüllt. Kurz vor der Elektrode bzw. Anode 6 beginnt ein etwa 1 mm breiter und mehrere Zentimeter tiefer Rundumspalt 9, der einen durchgehenden elektrisch leitenden Bewuchs verhindert. Der Abschirmzylinder 8 ist zumindest in der Nähe der Anode 6 von einer Außenhülse (nicht dargestellt) umgeben, die aus einem Material besteht, das ein Abblättern von elektrisch leitendem Bewuchs verhindert. Ein derartiges Material ist z.B. Elektrographit. Die Bewegbarkeit der Anode 6 samt Montagestab 7 und Abschirmzylinder 8 ist durch einen Doppelpfeil 10 angedeutet.

Zwischen der Anode 6 und den Substratzylindern 2 bildet sich eine Glimmentladung 11 aus. Das Hüllrohr 1 ist über Flansche 12 mit Dichtringen 13 aus einem ausheizbaren Kunststoff mit der übrigen Apparatur 14, 15 verbunden. Die durch einen Pfeil 16 angedeutete Gaszufuhr erfolgt auf der anodenabgewandten Seite, die durch einen Pfeil 17 angedeutete Gasentsorgung auf der Anodenseite.

In Fig. 2 ist ein Ausschnitt aus einer Vorrichtung zur Außenbeschichtung schematisch dargestellt. Fig. 2 wird in Beispiel 4 näher erläutert.

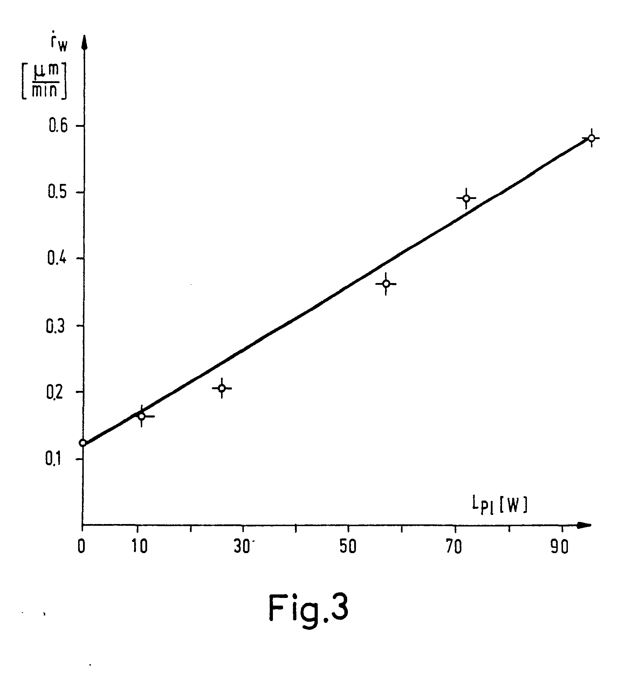

Fig. 3 zeigt die Wolfram-Abscheiderate $r_w$ als Funktion der Plasmaleistung $L_{p1}$ bei sonst konstanten Parametern (Gesamtdruck $P_{ges} = 12$ hPa, Durchflußraten $Q(WF_6) = 50$ cm$^3$/min, $Q(H_2) = 400$ cm$^3$/min, $Q(Ar) = 362$ cm$^3$/min, Substrattemperatur etwa 412°C). Das experimentelle Resultat ist eine in etwa lineare Zunahme der Wachstumsrate $r_w$ mit zunehmender Plasmaleistung im Bereich 0 bis 100 Watt. Bei etwa 200 bis 250 Watt wird die Sättigung erreicht (hier nicht dargestellt).

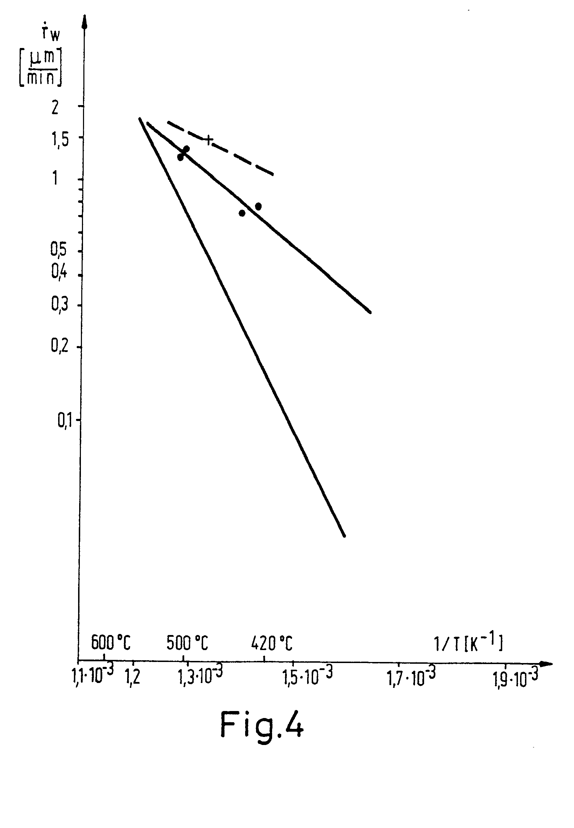

In Fig. 4 ist die Wolfram-Abscheiderate als Funktion der reziproken Substrattemperatur bei sonst konstanten Parametern und $p_{ges} = 10$ hPa in einem Arrhenius-Plot aufgetragen. Die unterste Gerade bezieht sich auf eine rein thermische Abscheidung ($L_{p1} = 0$ Watt), die mittlere auf eine Abscheidung bei einer Plasmaleistung von 90 Watt und die oberste auf eine Plasmaleistung von 156 Watt. Mit zunehmender Plasmaleistung ergibt sich eine immer geringere Temperaturabhängigkeit und eine zunehmende Wachstumsrate $r_w$, was insgesamt einer starken Abnahme der Aktivierungsenergie für die Oberflächenreaktion entspricht.

Beispiel 1

Zur Herstellung von Wolframzylindern der Dicke 50$\mu m$ werden die zu Fig. 3 angegebenen Parameterwerte angewandt. Bei einer Substrattemperatur von 410°C und einer plasmaleistung von 150 Watt folgt aus einer Wachstumsrate von 1$\mu m$ pro Minute eine Gesamtdauer der Beschichtung von 50 Minuten.

Der 5 cm tiefe Rundumspalt 9 (Fig. 1) in dem Abschirmzylinder 8 wird während der glimmentladungsaktivierten Reaktion fast ausschließlich durch das Reaktionsendprodukt Fluorwasserstoff und durch Wasserstoff (der im Reaktionsraum im Überschuß vorhanden ist) gefüllt. Ein Bewuchs der Spaltinnenseiten mit Wolfram tritt nur im Bereich der Eintrittsöffnung des Spalts 9 auf und nicht in der Tiefe des Spalts 9.

Als Substratzylinder werden Pyrographit-Zylinder benutzt (Innendurchmesser und Höhe etwa 28 cm, Wandstärke 250$\mu m$). Bei Abkühlung schrumpft der Wolframzylinder stärker als der Pyrographit-Zylinder. Der Wolframzylinder kann daher bei glatter Innenfläche des Pyrographit-Zylinders und nach Beseitigung der Randumwachsung mit Wolfram z.B. mit einem NdYAG-Laserschneidgerät einfach aus dem Pyrographit-Zylinder herausgezogen werden.

Als Alternative werden Kupfer-Substratzylinder mit den gleichen Abmessungen verwendet. Da Kupfer beim Abkühlen auf Wolfram aufschrumpft, wird es nach der Beschichtung mit einer Ätzlösung bestehend aus 5 g $FeCl_3$ auf 100 ml Wasser und 30 ml HCl in einigen Stunden abgeätzt.

Beispiel 2

Zur Herstellung von Wolframzylindern mit etwa 5% $ThO_2$ werden folgende Parameter angewandt: Gasflüsse: $Q(WF_6)$ = 25 cm³/min, $Q(H_2)$ = 400 cm³/min, $Q_1(Ar)$ = 62 cm³/min, $Q_2(Ar)$ = 300 cm³/min. $Q_2(Ar)$ gibt dabei den Argonstrom durch einen Sättiger an, der $Th(fod)_4$ enthält. Der Gesamtdruck im Reaktor beträgt 10 hPa und die Substrattemperatur wird auf 370°C eingeregelt. Bei einem Entladestrom von 0,3 A ergibt sich eine Plasmaleistung von etwa 170 Watt. Die Sättigertemperatur wird auf 145°C eingestellt. Aus dem Dampfdruck von $Th(fod)_4$, der bei dieser Temperatur 0,24 hPa beträgt, dem Argondurchsatz $Q_2(Ar)$ und dem Gesamtdruck im Sättiger von etwa 20 hPa erhält man einen $Th(fod)_4$-Massenfluß von 3.6 cm³/min. Nach einer Beschichtungsdauer von 2 Stunden erhält man eine Zylinderinnenbeschichtung von etwa 50µm Dicke.

Als Substrate werden Quarzzylinder verwendet, die durch eine 10 Minuten lange $Th(fod)_4$-Pyrolyse bei etwa 450°C Wandtemperatur mit einer höchstens 1µm dünnen Zwischenschicht, bestehend aus Thorium und Kohlenstoff, beschichtet worden sind. Auf diese Zwischenschicht, die die starke Oberflächenhaftung von Wolfram auf Quarz unterbindet, wird anschließend eine 3µm dicke Wolframschicht aufgebracht. Die Dauer dieser Beschichtung beträgt ebenfalls 10 Minuten.

Nach der Gesamtbeschichtungsdauer von 200 Minuten und Abkühlung der Zylinder auf Raumtemperatur können die thorierten Wolframzylinder einfach aus den Quarz-Substratzylindern herausgezogen werden, da die linearen thermischen Ausdehnungskoeffizienten mit $5.10^{-7}K^{-1}$ für Quarz und $4,5.10^{-6}K^{-1}$ für Wolfram sich stark unterscheiden.

Beispiel 3

Beispiel 2 wird abgeändert mit der Maßgabe, daß noch eine weitere Dotierung dem Ausgangsgasgemisch beigegeben wird, nämlich $ReF_6$. Die Gasphasenzusammensetzung besteht dann aus 50 cm³/min $WF_6$, 400 cm³/min $H_2$, 400 cm³/min Ar, 2 cm³/min $ReF_6$ und etwa 2 cm³/min $Th(tfa)_4$. Die Plasmaleistung beträgt 280 Watt. Die so hergestellten Schichten enthalten mit 4% Rhenium dotiertes Wolfram sowie etwa 4% $ThO_2$. Damit wird ein Material hergestellt, das gegenüber dem W + $ThO_2$-Material den Vorteil einer höheren Duktilität im Niedertemperaturbereich in Richtung Raumtemperatur aufweist. Die $ThO_2$-Dotierung verbessert hingegen die Warmfestigkeit und Duktilität bei Betriebstemperaturen von 2000 K.

Beispiel 4

In der in Fig. 2 dargestellten Vorrichtung mit einer Reaktorwand 21 aus Quarz wird eine Außenbeschichtung eines Zylinderrohres 22 (oder mehrerer übereinandergestapelter Substratzylinder) aus Edelstahl mit einer elektrisch leitenden Schicht durchgeführt. Das Zylinderrohr oder die Substratzylinder sitzen auf einem keramik-isolierten Heizstab 25. Zwischen dem Heizstab und dem Zylinderrohr ist gegebenenfalls ein Außenmantel 251 aus Edelstahl (V2A) angeordnet. Dadurch können die Substrate vorgeheizt werden und es kann ein schneller Wärmeausgleich durchgeführt werden.

Das Zylinderrohr 22 (Außendurchmesser 3 cm) ist als Kathode für eine Glimmentladung 211 geschaltet. Als Anode dient ein gut zentrierter koaxialer Ring 26 aus Edelstahl, Wolfram oder Molybdän mit Anodenzuführung 261. Wenn der Ring 26 einen Durchmesser von 7 cm hat, befindet er sich in einem Abstand von 2 cm vom Zylinderrohr 22 bzw. von den Substratzylindern.

Die Substratzylinderanordnung und der Heizstab werden vermittels einer Vakuum-Schiebedurchführung (nicht dargestellt) und einem Linearantrieb (ebenfalls nicht dargestellt) — nach Zünden der Glimmentladung in dem Gasgemisch wie in Beispiel 1 — mit einer Geschwindigkeit von 20 Sekunden pro Periode entsprechend 1 cm/s relativ zum reaktorfesten Anodenring 26 hin- und herbewegt, was durch einen Doppelpfeil 210 angedeutet ist. Die Gaszufuhr ist durch einen Pfeil 216 angedeutet.

Entladungsparameter und Substrattemperatur entsprechen Beispiel 1, ebenso die Beschichtungsdauer. Der als Substratzylindermaterial verwendete Edelstahl schrumpft bei Abkühlung stärker als Wolfram und haftet auch nicht auf dem Wolfram, so daß die Substratzylinder aus den entstandenen Wolframzylindern leicht herausgezogen werden können.

**Patentansprüche**

1. Verfahren zur reaktiven Abscheidung von rohrförmigen Körpern aus elektrisch leitendem Material aus einer strömenden Gasphase auf einem rohrförmigen Substrat, wobei zwischen einer Innenelektrode und einer Außenelektrode, von denen eine rohrförmig ausgebildet ist und als Substrat dient, eine Glimmentladung erzeugt wird, dadurch gekennzeichnet, daß

(a) eine gesteuerte Hin- und Herbewegung der Innenelektrode relativ zur Außenelektrode in Rohrrichtung erfolgt,

(b) zwischen der Innenelektrode und der Außenelektrode eine lokal begrenzte Glimmentladungszone erzeugt und während der Abscheidung beibehalten wird,

(c) Gasbarrieren geschaffen werden, um die Bildung von elektrisch leitenden Schichten auf elektrisch isolierenden Konstruktionsteilen im Reaktionsraum zu verhindern, und

(d) die Temperatur im Substratbereich auf einem niedrigen. Wert konstant gehalten wird, bei dem die thermische Abscheiderate klein ist gegenüber der Abscheiderate mit Glimmentladung.

2. Verfahren nach Anspruch 1, dadurch gekennzeichnet, daß das elektrisch leitende Material auf der Innenseite der als Substrat dienenden und somit rohrförmig ausgebildeten Außenelektrode abgeschieden wird, die als Kathode geschaltet wird.

3. Verfahren nach Anspruch 1, dadurch gekennzeichnet, daß das elektrisch leitende Material auf der Außenseite der als Substrat dienenden und somit rohrförmig ausgebildeten Innenelektrode abgeschieden wird, die als Kathode geschaltet wird.

4. Verfahren nach Anspruch 1, dadurch gekennzeichnet, daß bei der Abscheidung von Mehrkomponentenmaterial bei den Maßnahmen (b) und (d) die in der Glimmentladungszone verbrauchte Plasmaleistung gegenüber der thermischen Leistungszu- oder -abführung so hoch eingestellt wird, daß die Zusammensetzung von abgeschiedenem elektrisch leitendem Mehrkomponentenmaterial im wesentlichen durch die Anteile der abzuscheidenden Konstituenten in der Gasphase vorgegeben wird.

5. Verfahren nach Anspruch 4, dadurch gekennzeichnet, daß bei der Abscheidung von Mehrkomponentenmaterial die Temperatur im Substratbereich auf einem Wert konstant gehalten wird, bei dem die thermische Abscheiderate höchstens ein Zehntel der Abscheiderate mit Glimmentladung beträgt.

6. Verfahren nach Anspruch 1, dadurch gekennnzeichnet, daß die Bildung von elektrisch leitenden Schichten auf elektrisch isolierenden Konstruktionsteilen verhindert wird (Maßnahme (c))

(α) durch Ausbildung von Spalten in den elektrisch isolierenden Konstruktionsteilen oder von Spalten, bei denen mindestens ein Teil der Innenfläche aus elektrisch isolierendem Material besteht, wobei die Spalte so ausgebildet sind, daß sie während der reaktiven Abscheidung fast ausschließlich durch gasförmige Reaktionsendprodukte gefüllt sind, und/oder

(β) durch geeignete Wahl des Materials, aus dem de elektrisch isolierenden Konstruktionsteile wenigstens an der Oberfläche bestehen, so daß über eine Ätzreaktion der strömenden Gasphase mit der Oberfläche dieser Teile ein Gas entsteht, und/oder

(γ) durch eine zusätzliche Inertgasspülung.

7. Verfahren nach Anspruch 1 und 3, dadurch gekennzeichnet, daß bei der Maßnahme (b) die lokale Begrenzung der Glimmentladungszone durch

(α) Formgebung und geometrische Dimensionierung der nicht als Substrat dienenden Elektrode und deren Oberflächenabstände zur rohrförmigen Elektrode nach Maßgabe des Paschen-Gesetzes und/oder

(β) Isolationsumhüllung der Stromzuführung zur Innenelektrode, sofern diese nicht als Substrat dient, gegebenenfalls unter

(γ) Ausbildung von mindestens einem umlaufenden Spalt in der Isolationsumhüllung oder einem Spalt, bei dem mindestens ein Teil der Innenfläche aus elektrisch isolierendem Material besteht, wobei der Spalt so ausgebildet ist, daß er während der reaktiven Abscheidung fast ausschließlich durch gasförmige Reaktionsendprodukte gefüllt ist, und/oder

(δ) eine Längsausdehnung der metallischen Oberfläche der nicht als Substrat dienenden Elektrode, die in Rohrrichtung weniger als ein Drittel der Längsausdehnung des Substrats beträgt, eingestellt wird.

8. Verfahren nach Anspruch 1, dadurch gekennzeichnet, daß bei der Maßnahme (a) die Innenelektrode in Rohrrichtung periodisch oder aperiodisch gesteuert längs der Außenelektrode hin- und herbewegt wird.

9. Verfahren nach Anspruch 1, dadurch gekennzeichnet, daß bei der Maßnahme (d) das gesamte rohrförmige Substrat durch einzelne, getrennt regelbare Heiz- bzw. Kühlzonen und/oder durch Wahl eines Materials oder einer Vorrichtung mit schnellem Wärmeausgleich trotz der lokalen Wärmebelastung in der Glimmentladungszone auf annähernd konstanter Temperatur gehalten wird.

10. Verfahren nach Anspruch 1, dadurch gekennzeichnet, daß das rohrförmige Substrat zylinderförmig und die nicht als Substrat dienende Elektrode rotationssymmetrisch gewählt werden, wobei das rohrförmige Substrat gegebenenfalls aus mehreren Einzelrohren übereinandergestapelt wird und die nicht als Substrat dienende Elektrode koaxial angeordnet wird.

11. Verfahren nach Anspruch 1, dadurch gekennzeichnet, daß der strömenden Gasphase ein Inertgas zugesetzt wird.

12. Verfahren nach Anspruch 1, dadurch gekennzeichnet, daß die strömende Gasphase bei der Abscheidung von Mehrkomponentenmaterial mindestens ein Halogenid oder Carbonyl von Wolfram, Molybdän, Tantal, Niob, Rhenium, Hafnium, Iridium, Osmium, Platin, Rhodium, Ruthenium und/oder Zirkonium und als weitere Komponente mindestens eine metallorganische Verbindung eines Elements der Gruppe IIIb des Periodensystems sowie zusätzlich ein Inertgas und gegebenenfalls Wasserstoff enthält.

13. Verfahren nach Anspruch 11 und 12, dadurch gekennzeichnet, daß die strömende Gasphase Wolframhexafluorid, Wasserstoff und mindestens eine metallorganische Thoriumverbindung enthält und daß ein elektrisch leitendes Material, bestehend aus Wolfram, Wolframcarbid und Thoriumoxid, abgeschieden wird.

14. Verfahren nach Anspruch 11 und 13, dadurch gekennzeichnet, daß das Inertgas über zwei getrennt regelbare Gasflußwege zugesetzt wird, wobei eine Inertgaszuführung durch einen, mit der pulverförmigen metallorganischen Thoriumverbindung gefüllten, vorgeheizten Sättiger erfolgt.

15. Verfahren nach Anspruch 13, dadurch gekennzeichnet, daß der strömende Gasphase zusätzlich noch Rheniumhexafluorid beigegeben wird.

16. Verfahren nach Anspruch 1 oder 10, dadurch gekennzeichnet, daß ein rohrförmiges Substrat verwendet wird, das aus Pyrographit, Quarz, Molybdän oder Kupfer besteht, und daß das rohrförmige Substrat nach beendeter Abscheidung entfernt wird.

17. Verfahren nach Anspruch 1 oder 15, dadurch gekennzeichnet, daß als Substrat ein Quarzzylinder verwendet wird, der durch Pyrolyse einer metallorganischen Thoriumverbindung mit einer dünnen, auf Wolfram nicht haftenden Zwischenschicht aus Thoriumcarbid und Kohlenstoff thermisch vorbeschichtet wird, worauf dann das elektrisch leitende Material abgeschieden wird und nach Beendigung der Abscheidung und Abkühlung als selbsttragender Zylinder aus dem Quarzrohr herausgezogen wird.

18. Verfahren nach Anspruch 1, 4, 5 oder 12, dadurch gekennzeichnet, daß die Glimmentladung beim Umschalten auf eine andere Gaszusammensetzung nicht abgeschaltet wird.

## Revendications

1. Procédé pour le dépôt réactif de corps tubulaires en matériau électroconducteur à partir d'une phase gazeuse en circulation sur un substrat tubulaire, selon lequel une décharge par lueur est réalisée entre une électrode intérieure et une électrode extérieure dont l'une est tubulaire et sert de substrat, caractérisé en ce que

(a) un mouvement de va-et-vient commandé de l'électrode intérieure par rapport à l'électrode extérieure s'effectue dans la direction du tube,

(b) entre l'électrode intérieure et l'électrode extérieure est réalisée une zone de décharge par lueur localement limitée et maintenue pendant le dépôt,

(c) des barrières de gaz sont formées pour empêcher la formation de couches électroconductrices sur des parties de construction électroisolantes dans l'enceinte de réaction et

(d) la température dans la zone du substrat est maintenue constante à une valeur basse, la vitesse de dépôt thermique étant faible comparativement à la vitesse du dépôt à décharge par lueur.

2. Procédé selon la revendication 1, caractérisé en ce que le matériau électroconducteur est déposé sur la face intérieure de l'électrode extérieure servant de substrat et réalisée de ce fait de façon tubulaire, qui est montée en cathode.

3. Procédé selon la revendication 1, caractérisé en ce que le matériau électroconducteur est déposé sur la face extérieure de l'électrode intérieure servant de substrat et formée de ce fait de façon tubulaire, qui est montée en cathode.

4. Procédé selon la revendication 1, caractérisé en ce que lors du dépôt de matériau à plusieurs composants, lors des dispositions (b) et (d) la puissance de plasma consommée dans la zone de décharge par lueur est établie si élevée par rapport à l'amenée ou l'évacuation de puissance thermique que la composition du matériau à plusieurs composants électroconducteurs déposé est essentiellement déterminée par les parts en composants à séparer de la phase gazeuse.

5. Procédé selon la revendication 4, caractérisé en ce que lors du dépôt de matériau à plusieurs composants, la température dans la zone du substrat est maintenue constante à une valeur à laquelle la vitesse de dépôt thermique est d'au maximum un dixième de la vitesse de dépôt à décharge par lueur.

6. Procédé selon la revendication 1, caractérisé en ce que la formation de couches électroconductrices sur des parties de construction électroisolantes est empêchée (disposition (c)

(α) par formation de fentes dans les parties de construction électroisolantes ou de fentes où au moins une partie de la surface intérieure est constituée par du matériau électroisolant, la fente étant formée de façon que, lors du dépôt réactif, elle soit exclusivement remplie de produits de réaction gazeux terminaux, et/ou

(β) par un choix approprié du matériau dont sont constituées, au moins superficiellement, les parties de construction électroisolantes de façon qu'il se forme un gaz par l'intermédiaire d'une réaction de décapage de la phase gazeuse en circulation avec la surface de ces parties, et/ou

(γ) par un rinage de gaz inerte additionnel.

7. Procédé selon les revendications 1 et 3, caractérisé en ce que lors de la disposition (b) la limitation locale de la zone de décharge par lueur est établie par

(α) façonnage et dimensionnement géométrique de l'électrode qui ne sert pas de substrat et dont les distances entre la surface et l'électrode tubulaire sont conformément à la loi de Paschen et/ou.

(β) enrobage avec un isolant de l'amenée de courant à l'électrode intérieure pour autant que celle-ci ne fait pas office de substrat, le cas échéant avec

(γ) formation d'au moins une fente circulaire continue dans l'enrobage d'isolant ou une fente dont au moins une partie de la surface intérieure est constituée par du matériau électroisolant, la fente étant formée de façon que, lors du dépôt réactif, elle ne soit uniquement remplie de produits de réaction gazeux terminaux et/ou

(δ) une étendue longitudinale de la surface métallique de l'électrode ne faisant pas office de substrat qui est inférieure, dans la direction du tube, à une troisième partie de l'étendue longitudinale du substrat.

8. Procédé selon la revendication 1, caractérisé en ce que lors de la disposition (a) l'électrode intérieure est animée de mouvements de va-et-vient de façon commandée périodique ou apériodique le long de l'électrode extérieure.

9. Procédé selon la revendication 1, caractérisé en ce que lors de la disposition (d), tout le substrat tubulaire est maintenu à une température pratiquement constante par des zones de chauffage respectivement refroidissement commandées séparément individuelles et/ou le choix de matériau ou d'un dispositif présentant une compensation thermique rapide malgré la charge thermique locale dans la zone de décharge par lueur.

10. Procédé selon la revendication 1, caractérisé en ce que le substrat tubulaire est cylindrique et l'électrode ne servant pas de substrat est à symétrie de révolution, le substrat tubulaire étant constitué le cas échéant par plusieurs tubes individuels empilés et l'électrode ne servant pas de substrat étant disposée de façon coaxiale.

11. Procédé selon la revendication 1, caractérisé en ce que la phase gazeuse en circulation est additionnée d'un gaz inerte.

12. Procédé selon la revendication 1, caractérisé en ce que lors du dépôt d'un matériau à plusieurs composants la phase gazeuse en circulation contient au moins un halogénure ou carbonyle de tungstène, molybdène, tantale, niobium, rhénium, hafnium, iridium, osmium, platine, rhodium, ruthénium et/ou zirconium et comme autre composant au moins un composé organo-métallique d'un élément du groupe IIIb de la classification périodique des éléments ainsi qu'en outre un gaz inerte et, le cas échéant, de l'hydrogène.

13. Procédé selon les revendications 11 et 12, caractérisé en ce que la phase gazeuse en circulation contient de l'hexafluorure de tungstène, de l'hydrogène et au moins un composé de thorium organo-métallique et en ce qu'un matériau électro-conducteur constitué par du tungstène, du carbure de tungstène et de l'oxyde de thorium est déposé.

14. Procédé selon les revendications 11 et 13, caractérisé en ce que le gaz inerte est ajouté par l'intermédiaire de deux voies de circulation de gaz séparément réglables, une amenée de gaz inerte s'effectuant à travers un saturateur préchauffé rempli d'un composé de thorium organométallique pulvérulent.

15. Procédé selon la revendication 13, caractérisé en ce que la phase gazeuse en circulation est en outre additionnée d'hexafluorure de rhénium.

16. Procédé selon la revendication 1 ou 2, caractérisé par l'utilisation d'un substrat tubulaire qui est constitué par du pyrographite, du quartz, du molybdène ou du cuivre et en ce que le substrat tubulaire est enlevé après le dépôt.

17. Procédé selon la revendication 1 ou 15, caractérisé par l'utilisation d'un cylindre en quartz comme substrat qui est préalablement thermiquement recouvert d'une couche par pyrolyse d'un composé de thorium organo-métallique d'une couche intermédiaire mince qui n'adhère pas au tungstène et qui est constituée par du carbure de thorium et du carbone, après quoi le matériau électroconducteur est déposé et retiré du tube en quartz comme cylindre auto-portant après le dépôt et le refroidissement.

18. Procédé selon la revendicaton 1, 4, 5 ou 12, caractérisé en ce que lors du passage à une autre composition de gaz la décharge par lueur n'est pas interrompue.

## Claims

1. A method for the reactive deposition of tubular bodies of an electrically conductive material from a flowing gas phase on a tubular substrate, in which a glow discharge is produced between an inner electrode and an outer electrode, one of which is constructed to be tubular and serves as a substrate, characterized in that

(a) a controlled reciprocating movement occurs of the inner electrode relative to the outer electrode, in the direction of the tube,

(b) a localized glow discharge zone is produced between the inner electrode and the outer electrode and is maintained during the deposition,

(c) gas barriers are formed to prevent the formation of electrically conductive layers on electrically insulating structural parts in the reaction space, and

(d) the temperature in the substrate area is kept constant at a low value at which the thermal deposition rate is small as compared with the deposition rate with glow discharge.

2. A method as claimed in Claim 1, characterized in that the electrically conductive material is deposited on the inside of the outer electrode which serves as a substrate and hence is constructed to be tubular and arranged as a cathode.

3. A method as claimed in Claim 1, characterized in that the electrically conductive material is deposited on the outside of the inner electrode which serves as a substrate and hence is constructed so as to be tubular and arranged as a cathode.

4. A method as claimed in Claim 1, characterized in that during the deposition of multicomponent material in the measures (b) and (d) the plasma power consumed in the glow discharge zone is adjusted to be so high with respect to the thermal power input or dissipation that the composition of deposited electrically conductive multicomponent material is determined substantially by the relative amounts of the constituents to be deposited in the gas phase.

5. A method as claimed in Claim 4, characterized in that during the deposition of multicomponent material the temperature in the substrate area is kept constant at a value at which the thermal deposition rate is at most 1/10 th of the deposition rate with glow discharge.

6. A method as claimed in Claim 1, characterized in that the formation of electrically conductive layers on electrically insulating structural parts is prevented (measure (c))

(α) by the formation of grooves in the electrically insulating structural parts or by forming grooves of which at least part of the inside consists of electrically insulating material, which grooves are formed so that during the reactive deposition they are filled substantially only by gaseous reaction end products, and/or

(β) by a suitable choice of the material of which the electrically insulating structural parts consist at least at the surface, so that by an etching reaction of the flowing gas phase with the surface of said parts a gas is formed and/or

(γ) by an additional inert gas rinsing.

7. A method as claimed in Claims 1 and 3, characterized in that in the measure (b) the spatial limitation of the glow discharge zone is adjusted by

(α) design and geometric proportioning of the electrode not serving as a substrate and of its surface distances to the tubular electrode according to Paschen's law, and/or

(β) insulation envelope for the current supply to the inner electrode, provided it does not serve as a substrate, while optionally

(γ) forming at least one circumferential groove in the insulation envelope or a groove of which at least part of the inner surface consists of electrically insulating material, which groove is formed so that during the reactive deposition it is filled substantially only by gaseous reaction end products and/or

(δ) a longitudinal expansion of the metallic surface of the electrode not serving as a substrate, which in the direction of the tube amounts to less than one third of the longitudinal expansion of the substrate.

8. A method as claimed in Claim 1, characterized in that in the measure (a) the inner electrode in the direction of the tube is reciprocated along the outer electrode while being moved periodically or aperiodically.

9. A method as claimed in Claim 1, characterized in that in measure (d) the overall tubular substrate is kept substantially at a constant temperature by individual separately controllable heating or cooling zones and/or by selecting a material or a device having a rapid thermal compensation inspite of the local thermal load in the glow discharge zone.

10. A method as claimed in Claim 1, characterized in that the tubular substrate is chosen to be cylindrical and the electrode not serving as a substrate is chosen to be rotationally symmetrical, the tubular substrate optionally being formed by stacking several individual tubes on top of each other, and the electrode not serving as a substrate being arranged coaxially.

11. A method as claimed in Claim 1, characterized in that an inert gas is added to the flowing gas phase.

12. A method as claimed in Claim 1, characterized in that, when a multicomponent material is deposited, the flowing gas phase comprises at least a halide or carbonyl of tungsten, molybdenum, tantalum, niobium, rhenium, hafnium, iridium, osmium, platinum, rhodium, ruthenium and/or zirconium and as a further constituent at least a metalorganic compound of an element of group III B of the periodic system together with an inert gas and if necessary hydrogen.

13. A method as claimed in Claims 11 and 12, characterized in that the flowing gas phase contains tungsten hexafluoride, hydrogen and at least one metalorganic thorium compound, and that an electrically conductive material consisting of tungsten, tungsten carbide and thorium oxide is deposited.

14. A method as claimed in Claims 11 and 13, characterized in that the inert gas is added via two separately controllable gas flow paths, one inert gas supply being carried out by a preheated saturator which is filled with the powdered metalorganic thorium compound.

15. A method as claimed in Claim 13, characterized in that rhenium hexafluoride is additionally added to the flowing gas phase.

16. A method as claimed in Claim 1 or 10, characterized in that a tubular substrate is used which consists of pyrographite, quarts, molydenum of copper and that the tubular substrate is removed after the deposition has been completed.

17. A method as claimed in Claim 1 or 15, characterized in that as a substrate a quarts cylinder is used which is precoated thermally by pyrolysis of a metalorganic thorium compound with a thin intermediate layer of thorium carbide and carbon not adhering to tungsten, on which the electrically conductive material is then deposited which, after completion of the deposition and cooling, is drawn out of the quartz tube as a self-supporting cylinder.

18. A method as claimed in Claim 1, 4, 5 or 12, characterized in that the glow discharge is not interrupted in case the gas composition is changed.

Fig.1

Fig.2

Fig.3

Fig.4